# EUROPÄISCHE PATENTANMELDUNG

(11) **EP 1 920 819 A1**
(43) Veröffentlichungstag der Anmeldung: **14.05.2008**
(21) Anmeldenummer: 07021376.4
(22) Anmeldetag: 02.11.2007
(51) Int. Cl.: B01D 53/46, B01D 53/68, C23C 16/44, F23G 7/06

(54) **Verfahren und Vorrichtung zur Reinigung der Abgase einer Siliziumdünnschicht-Produktionsanlage**

(30) Priorität: 08.11.2006 DE 102006052586
(71) Anmelder: SCHOTT Solar GmbH, 63755 Alzenau (DE)
(72) Erfinder: Lundszien, Dietmar, Dr., 81541 München (DE); Irsigler, Franz, 85417 Marzling (DE); Lechner, Peter, 85591 Vaterstetten (DE)
(74) Vertreter: Haft, von Puttkamer, Berngruber

(57) **Zusammenfassung**

Eine Anlage zur Herstellung von Siliziumdünnschicht-Solarzellen weist wenigstens eine Kammer (1) auf, in der die Siliziumdünnschicht während des Produktionsprozesses aus Siliziumhydrid-Gas abgeschieden. Anschließend wird die Kammer (1) durch einen Ätzprozess z. B. mit Schwefelhexafluorid als Ätzgas von Verunreinigungen gereinigt. Das während des Produktionsprozesses gebildete, Siliziumhydrid enthaltende Abgas wird einem Brenner (6) zugeführt und anschließend filtriert. Das während des Ätzprozesses gebildete, Schwefelhexafluorid enthaltende Abgas, wird mit Wasser gewaschen, nach dem es einem Brenner zugeführt worden ist. Die durch Verbrennung des Schwefelhexafluorids gebildete Flusssäure wird aus dem Waschwasser abgetrennt.

## Beschreibung

Die Erfindung bezieht sich auf ein Verfahren und eine Vorrichtung zur Abgasreinigung einer Anlage, mit der aus Siliziumhydrid ein Siliziumfilm abgeschieden wird, gemäß dem Oberbegriff des Anspruchs 1 bzw. 5.

Das Silizium einer Siliziumdünnschicht-Solarzelle wird in einer Kammer durch chemische Dampfabscheidung, insbesondere durch Plasma gestützte chemische Dampfabscheidung oder PECVD(plasma enhanced chemical vapour deposition) aus einem Prozessgas aus Siliziumhydrid, Wasserstoff und z.B. Stickstoff als Trägergas hergestellt. Dabei scheidet sich Silizium nicht nur auf dem Substrat, also der Solarzelle, sondern auch an den Kammerwänden und der Elektrode ab, mit der das Plasma erzeugt wird.

Die Kammer muss daher nach dem Produktionsprozess gereinigt werden. Dazu wird ein PECVD-Ätzprozess mit einem Ätzgas aus einem Nichtmetallfluorid, insbesondere Schwefelhexafluorid und Stickstofftrifluorid, und Sauerstoff sowie Stickstoff als Trägergas durchgeführt, um das in der Kammer abgeschiedene Silizium in flüchtige Siliziumfluorverbindungen überzuführen. Während des Ätzprozesses wird das eingesetzte Nichtmetallfluorid jedoch nur zu einem geringen Teil zu Siliziumfluorverbindungen umgesetzt. Der überwiegende Teil des Nichtmetallfluorids bleibt hingegen ungenutzt.

Sowohl beim Produktionsprozess wie beim Ätzprozess muss die Kammer abgepumpt werden, um den für die Plasmabildung erforderlichen Unterdruck aufrecht zu erhalten. Zur Reinigung des abgepumpten Prozessabgases und Ätzabgases sind zwei Methoden gebräuchlich.

Zum einen wird sowohl das Siliziumhydrid enthaltende Prozessabgas wie das während des Ätzprozesses gebildete Abgas, das das Ätzgas und Silliziumfluorid enthält, einem Brenner zugeführt, dem eine Wascheinrichtung nachgeschaltet ist. Falls Schwefelhexafluorid als Ätzgas verwendet wird, wird das Siliziumhydrid zu Siliziumdioxid und Wasser, das Schwefelhexafluorid zu Schwefeldioxid und Flusssäure und das Siliziumfluorid zu Siliziumdioxid und Flusssäure verbrannt, wobei das Siliziumdioxid, Schwefeldioxid und Flusssäure mit der Wascheinrichtung aus dem Verbrennungsabgas mit Wasser ausgewaschen werden. Demgegenüber wird z. B. Stickstofftrifluorid als Ätzgas zu Stickoxiden verbrannt. Dabei ist nicht nur der Wasserverbrauch erheblich, vielmehr wird eine erhebliche Menge an Abwasser gebildet, welches neben dem schwer abzutrennenden Siliziumdioxidschlamm die aggressive Flusssäure enthält, sodass die Abwasserreinigung erhebliche Probleme bereitet.

Nach der anderen Methode werden das Prozessabgas und das während des Ätzprozesses gebildete Abgas, das Schwefelhexafluorid bzw. Stickstofftrifluorid als Ätzgas und Siliziumfluorid enthält, getrennt gereinigt. Dabei wird das Prozessabgas einem Brenner zugeführt und der aus dem Siliziumhydrid durch Verbrennung gebildete Siliziumdioxidstaub mit einem Staubfilter abfiltriert, während das Schwefelhexafluorid bzw. Stickstofftrifluorid aus dem während des Ätzprozesses gebildeten Abgas recycelt wird, um erneut als Ätzgas eingesetzt werden zu können. Die Reinigung des Abgases zum Recyceln des Ätzgases ist jedoch mit einem erheblichen apparativen Aufwand verbunden.

Aufgabe der Erfindung ist es daher, ein Verfahren zur Reinigung des Abgase einer Siliziumdünnschicht-Produktionsanlage bereit zu stellen, das mit einem geringen apparativen Aufwand und geringen Mengen an Waschwasser auskommt.

Dies wird erfindungsgemäß mit dem im Anspruch 1 gekennzeichneten Verfahren erreicht. In den Ansprüchen 2 bis 4 sind vorteilhafte Ausgestaltungen des erfindungsgemäßen Verfahrens wiedergegeben. Der Anspruch 5 hat eine bevorzugte Vorrichtung zur Durchführung des erfindungsgemäßen Verfahrens zum Gegenstand, welche durch die Merkmale der Ansprüche 6 bis 9 in vorteilhafter Weise weiter ausgebildet wird.

Nach dem erfindungsgemäßen Verfahren wird das während des Produktionsprozesses, also der Abscheidung des Siliziumfilms auf dem Substrat gebildete Abgas, das überschüssiges Siliziumhydrid enthält, einem Brenner hinzugeführt, um es zu Siliziumdioxid-Staub zu verbrennen, der leicht abfiltriert werden kann. Desgleichen wird das während des Ätzprozesses gebildete z. B. Schwefelhexafluorid oder Stickstofftrifluorid enthaltende Abgas zunächst verbrannt, das Schwefeldioxid bzw. Stickoxide und Flusssäure (HF) enthaltende Verbrennungsabgas wird anschließend mit Wasser gewaschen und die Flusssäure aus dem Waschwasser abgetrennt.

Das beim Reinigungs- oder Ätzprozess durch Ätzen aus dem in der Kammer als Verunreinigung abgeschiedenen Silizium, in relativ geringer Menge gebildete Siliziumfluorid in dem Abgas wird hierbei ebenfalls zu Siliziumdioxid und Flusssäure verbrannt, wobei das Siliziumdioxid gegebenenfalls zusammen mit der Flusssäure abgetrennt werden kann.

Das Abtrennen der Flusssäure kann dabei durch Ausfällen, z.B. mit Kalziumionen und anschließendes Abfiltrieren des ausgefüllten Niederschlags erfolgen. Damit sind erfindungsgemäß nur einfache apparative Einrichtungen, wie Brenner, Wäscher und Filtriereinrichtungen erforderlich.

Da erfindungsgemäß nur das Verbrennungsabgas mit Wasser gewaschen wird, das aus dem während des Ätzprozesses anfallenden Abgas gebildet wird, und der Ätzprozess wesentlich weniger Zeit in Anspruch nimmt als der Produktionsprozess, fällt erfindungsgemäß auch nur eine geringe Menge an Waschwasser an. Dieses Waschwasser enthält zudem nur eine geringe Menge an Siliziumdioxid, nämlich nur das Siliziumdioxid, das aus dem beim Ätzprozess entstandenen Siliziumfluorid durch Verbrennung im Brenner entstanden ist. Zudem ist die Konzentration der Flusssäure in dem Waschwasser relativ hoch, was deren Ausfällung erleichtert.

In der Praxis wird damit die Siliziumdioxidfracht in dem fluorhaltigen Abwasser um einen Faktor von ca. 8 bis 20 reduziert. Da die Wascheinrichtung nur noch während des Reinigungsprozesses, also nur 10 bis 20 % der Zeit laufen muss, wird das zu entsorgende fluorhaltige Abwasservolumen entsprechend reduziert.

Zugleich stellen die erfindungsgemäß zur Reinigung verwendeten Einrichtungen, nämlich Brenner, Wascheinrichtung und Filtriereinrichtung nicht nur kostengünstige sondern auch technisch bewährte Anlagenbestandteile dar. Da das während des Produktionsprozesses gebildete Abgas und das während des Ätzprozesses gebildete Abgas getrennt gereinigt werden, besteht zudem die Möglichkeit, die Reinigungseffizienz des jeweiligen Reinigungsprozesses zu optimieren.

Das erfindungsgemäße Verfahren kann bei einer Siliziumdünnschicht-Produktionsanlage mit einer oder mit mehreren Kammern angewendet werden. Bei Verwendung von zwei oder mehreren Kammern wird vorzugsweise abwechselnd in einer Kammer der Produktionsprozess durchgeführt, während die andere Kammer zur Reinigung dem Ätzprozess untergeworfen wird.

Als Siliziumhydrid-Gas wird vorzugsweise Monosilan (SiH₄) verwendet. Es wird im Gemisch mit Wasserstoff zugeführt. Als Trägergas wird vorzugsweise Stickstoff verwendet. So kann das Volumenverhältnis von SiH₄ zu H₂, z.B. 1 bis 50, insbesondere 8 bis 30 Standardliter/Minute H₂ zu 10 Standardliter/Minute SiH₄ betragen. Das Volumenverhältnis des Stickstoffes zu dem Gemisch aus SiH₄ und H₂ kann z.B. 2:1 bis 20:1 insbesondere 4:1 bis 8:1 betragen. Die Dauer der Abscheidung kann beispielsweise 20 bis 60 Minuten betragen.

Zur Abscheidung wird vorzugsweise das PECVD-Verfahren verwendet, vorzugsweise mit einem Unterdruck von 01 bis 0,5 Millibar. Der Unterdruck beim PECVD-Ätzverfahren liegt vorzugsweise in der gleichen Größenordnung.

Zum Ätzprozess wird ein Gemisch aus einem Nichtmetallfluorid-Ätzgas, insbesondere Schwefelhexafluorid (SF₆) oder Stickstofftrifluorid (NF₃) sowie Sauerstoff (O₂) verwendet. Das Volumenverhältnis des Nichtmetallfluorid-Ätzgases zu O₂ kann z.B. 2:1 bis 8:1, insbesondere 3:1 bis 4:1 Standardliter/Minute betragen. Als Trägergas wird für dieses Gemisch vorzugsweise ebenfalls Stickstoff eingesetzt. Das Volumenverhältnis des Stickstoffgases zu dem Gemisch aus dem Nichtmetallfluorid-Ätzgas und O₂ kann z.B. 2:1 bis 20:1, insbesondere 5:1 bis 8:1 betragen. Die Dauer der Reinigung kann z.B. 3 bis 10 Minuten betragen.

Zum Abtrennen der Flusssäure aus dem Waschwasser können die Fluoridionen beispielsweise mit Kalziumhydroxid oder einem wasserlöslichen Kalziumsalz ausgefällt werden.

Da das erfindungsgemäße Verfahren mit kostengünstigen Einrichtung durchgeführt werden kann, können diese Einrichtungen auch redundant eingesetzt werden, um die Sicherheit zu erhöhen. So kann beispielsweise jedem Brenner ein Ersatzbrenner zugeordnet sein, dem Staubfilter einen Ersatzfilter, der Wascheinrichtung eine Ersatzwascheinrichtung usw.

Die Verbindung der Kammer oder Kammern mit dem einen Brenner, dem ein Staubfilter nachgeschaltet ist und mit dem anderen Brenner, dem die Wascheinrichtung nachgeschaltet ist, erfolgt jeweils über ein Absperrorgan. Das Absperrorgan kann durch ein Ventil, einen Hahn oder dergleichen gebildet sein; beispielsweise kann ein Dreiwegehahn verwendet werden.

Nachstehend ist eine Ausführungsform der erfindungsgemäßen Vorrichtung anhand der beigefügten Zeichnung beispielhaft näher erläutert. Darin zeigen jeweils schematisch:
- Figur 1: eine Reinigungsvorrichtung für eine Kammer; und
- Figur 2: eine Reinigungsvorrichtung für zwei Kammern.

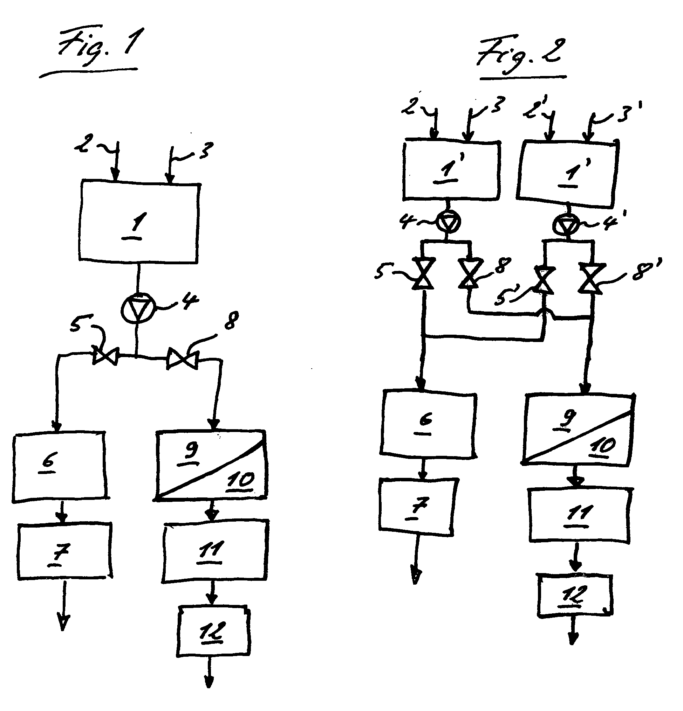

Gemäß Figur 1 weist eine Anlage zur Herstellung einer Siliziumdünnschicht/Solarzelle eine PECVD-Kammer 1 auf, der während dem Produktionsprozess gemäß dem Pfeil 2 ein Gas aus SiH₄ und H₂ sowie N₂ als Trägergas zugeführt wird, und während des Reinigungsprozesses gemäß dem Pfeil 3 ein Gemisch aus SF₆ (oder NF₃) und O₂ sowie N₂ als Trägergas.

Dabei wird mit einer Pumpe 4 ein Niederdruck von z.B. 0,3 Millibar in der Kammer 1 eingestellt.

Die Pumpe 4 ist einerseits über das Ventil 5 mit einem Brenner 6 verbunden, dem ein Filter 7 nachgeordnet ist, und andrerseits über ein Ventil 8 mit einem Brenner 9, der zugleich eine Wascheinrichtung 10 umfasst. Der Wascheinrichtung 10 ist ein Tank 11 mit einem Filter 12 für die Abwasserbehandlung, einschließlich Fluoridfällung, nachgeordnet.

Während des Produktionsprozesses ist das Ventil 5 geöffnet und das Ventil 8 geschlossen. Das von der Pumpe 4 aus der Kammer 1 abgepumpte Abgas, das SiH₄, H₂ und N₂ enthält, wird damit dem Brenner 6 zugeführt und dort zu SiO₂ und H₂O verbrannt, wobei der SiO₂-Staub mit dem Filter 7 abgetrennt wird, bevor das Abgas ins Freie abgegeben wird.

Während des Ätz- oder Reinigungsprozesses ist das Ventil 5 geschlossen und das Ventil 8 geöffnet. Das von der Pumpe 4 aus der Kammer 1 abgesaugte Abgas, das SF₆ (oder NF₃), O₂, Siliziumfluorid und N₂ enthält, wird damit dem Brenner 9 zugeführt und dort zu SO₂ bzw. NO_{X}, HF und SiO₂ verbrannt, welche mit der Wascheinrichtung 10 ausgewaschen werden. Das Waschwasser, das dem Tank 11 zugeführt wird, wird z. B. mit Kalziumhydroxid versetzt, um Kalziumfluorid auszufällen, das zusammen mit dem Siliziumdioxid mit dem Filter 12 abfiltriert wird, um als gereinigtes Abwasser abgegeben zu werden.

Die Vorrichtung nach Figur 2 unterscheidet sich im Wesentlichen von der nach Figur 1 dadurch, dass zwei PECVD-Anlagen 1, 1', mit jeweils einer Pumpe 4, 4' vorgesehen sind, wobei die Pumpen 4, 4', die Kammern 1, 1' über die Ventile 5, 8 bzw. 5', 8' mit dem Brenner 6 bzw. dem Brenner 9 verbinden.

Stattdessen können auch zwei Kammern vorgesehen sein, wobei für jede der beiden Kammern jeweils ein Brenner mit nachgeschaltetem Staubfilter und ein Brenner mit ein nachgeschalteter Wasch- und einer Abtrenneinrichtung für die Flusssäure vorgesehen ist. Dabei kann, um die Anlage bei Ausfall eines Brenners weiter betreiben zu können, z.B. für den Brenner mit nachgeschalteter Wascheinrichtung ein Ersatzbrenner vorgesehen sein, der mit der einen bzw. anderen Kammer verbindbar ist.

## Patentansprüche

1. Verfahren zur Reinigung der Abgase einer Anlage mit wenigstens einer Kammer (1, 1'), in der ein Produktionsprozess durchgeführt wird, bei dem aus Siliziumhydrid ein Siliziumfilm auf einem Substrat abgeschieden wird, wobei die Kammer (1, 1') nach der Produktion durch einen Ätzprozess mit einem Nichtmetallfluorid-Ätzgas von Verunreinigungen aus abgeschiedenem Silizium gereinigt wird, **dadurch gekennzeichnet, dass** das während des Produktionsprozesses gebildete Siliziumhydrid enthaltende Abgas einem ersten Brenner (6) zugeführt und anschließend zur Entfernung des durch Verbrennung des Siliziumshydrids gebildeten Siliziumdioxid-Staub mit einem ersten Filter (7) filtriert wird, und das während des Ätzprozesses gebildete, Nichtmetallfluorid-Ätzgas enthaltende Abgas, nach dem es einem zweiten Brenner (9) zugeführt worden ist, mit Wasser gewaschen wird, worauf die durch Verbrennung des Nichtmetallfluorid-Ätzgas gebildete Flusssäure aus dem Waschwasser ausgefällt und zusammen mit dem Siliziumdioxid, das durch Verbrennung des beim Ätzprozess entstandenen Siliziumfluorids gebildet wird, mit einem zweiten Filter (12) abgetrennt wird.

2. Verfahren nach Anspruch 1, **dadurch gekennzeichnet, dass** als Nichtmetallfluorid-Ätzgas Schwefelhexafluorid und/oder Stickstofftrifluorid verwendet wird.

3. Verfahren nach Anspruch 1, **dadurch gekennzeichnet, dass** die Anlage wenigstens zwei Kammern (1, 1') aufweist, wobei abwechselnd in der einen Kammer (1, 1') der Produktionsprozess durchgeführt wird, während die andere Kammer (1, 1') durch den Ätzprozess gereinigt wird.

4. Vorrichtung zur Durchführung des Reinigungsverfahrens nach einem der vorstehenden Ansprüche, **dadurch gekennzeichnet, dass** die wenigstens eine Kammer (1, 1') zur Abfuhr des während des Produktionsprozesses gebildeten, Siliziumhydrid enthaltenden Abgases über ein Absperrorgan mit einem ersten Brenner (6) verbindbar ist, dem ein erster Filter (7) zur Entfernung des durch Verbrennung des Siliziumhydrids gebildeten Siliziumdioxid-Staubs nachgeschaltet ist, und zur Abfuhr des während des Ätzprozesses gebildeten, Nichtmetallfluorid-Ätzgas enthaltenden Abgases über ein Absperrorgan mit einem zweiten Brenner (9) verbindbar ist, dem eine Wascheinrichtung (10) zum Auswaschen der durch Verbrennung des Nichtmetallfluorid-Ätzgases gebildeten Flusssäure aus den Verbrennungsgasen mit Wasser, eine Einrichtung zum Ausfällen der Flusssäure aus dem Waschwasser und ein zweiter Filter (12) zum Abtrennen der ausgefällten Flusssäure und des Siliziumdioxids, das durch Verbrennung des beim Ätzprozess entstandenen Siliziumfluorids gebildet wird, nachgeschaltet ist.

5. Vorrichtung nach Anspruch 4, **dadurch gekennzeichnet, dass** zusätzlich zu dem ersten Brenner (6) mit dem nachgeschalteten ersten Filter (7) und/oder dem zweiten Brenner (9) mit der Wascheinrichtung (10) jeweils ein Ersatzbrenner vorgesehen ist.

6. Vorrichtung nach Anspruch 4 oder 5, **dadurch gekennzeichnet, dass** die Anlage wenigstens zwei Kammern (1, 1') aufweist, in denen abwechselnd entweder der Produktionsprozess oder der Ätzprozess durchgeführt wird, wobei jede Kammer (1, 1') über ein Absperrorgan mit dem ersten Brenner (6) mit nachgeschaltetem Staubfilter (7) und über ein Absperrorgan mit dem zweiten Brenner (9) mit der Wasch- und Flusssäureabtrenneinrichtung verbindbar ist.

7. Vorrichtung nach Anspruch 4, **dadurch gekennzeichnet, dass** die Anlage wenigstens zwei Kammer (1, 1') aufweist und für jede der beiden Kammern (1, 1') jeweils ein erster Brenner (6) mit nachgeschaltetem ersten Filter (7) und ein zweiter Brenner (9) mit Wasch- und Flusssäureabtrenneinrichtung vorgesehen ist.

8. Vorrichtung nach Anspruch 6 und 7 oder 8, **dadurch gekennzeichnet, dass** die beiden Kammern (1, 1') mit wenigstens einem Ersatzbrenner verbindbar ist.

9. Verwendung des Verfahrens nach einem der Ansprüche 1 bis 3 zur Reinigung der Abgase einer Anlage zur Produktion von Siliziumdünnschicht-Solarzellen.
